# EUROPÄISCHE PATENTSCHRIFT

(11) **EP 3 058 314 B1**
(45) Veröffentlichungstag und Bekanntmachung des Hinweises auf die Patenterteilung: **29.08.2018**
(21) Anmeldenummer: 14795790.6
(22) Anmeldetag: 14.10.2014
(51) Int. Cl.: G01D 11/24, B81B 7/00

(54) **SENSORELEMENT**
SENSOR ELEMENT
ÉLÉMENT DÉTECTEUR

(30) Priorität: 15.10.2013 DE 102013220908
(43) Veröffentlichungstag der Anmeldung: 24.08.2016
(73) Patentinhaber: Continental Automotive GmbH, 30165 Hannover (DE)
(72) Erfinder: REITMEIER, Willibald, 93155 Hohenschambach (DE); GRASS, Philippe, 93053 Regensburg (DE); ANTE, Johannes, 93055 Regensburg (DE)
(86) Internationale Anmeldenummer: PCT/EP2014/071951
(87) Internationale Veröffentlichungsnummer: WO 2015/055609

(56) Entgegenhaltungen:
- DE-A1- 10 247 857
- DE-A1-102007 025 992
- DE-A1-102009 008 457
- US-A1- 2012 161 796

## Beschreibung

Die vorliegende Erfindung betrifft ein Sensorelement mit den Merkmalen des Oberbegriffes von Patentanspruch 1.

Es ist bekannt, Sensorelemente mit einem Funktionsgehäuse aus Metall zu versehen. Derartige Metallgehäuse finden insbesondere dann Verwendung, wenn Messelemente mit einer hohen Wärmeentwicklung vorhanden sind.

Ferner sind Sensorelemente bekannt, bei denen das Messelement in einem Funktionsgehäuse untergebracht ist, das als Kunststoffmoldgehäuse ausgebildet ist. Hierbei ist das Messelement in ein Kunststoffgehäuse eingeformt. Die entsprechenden Bauteile sind hierbei beispielsweise direkt mit der Kunststoffmasse umspritzt. Solche Funktionsgehäuse aus Kunststoff zeichnen sich durch eine hohe Medienbeständigkeit, eine relativ gute Temperaturbeständigkeit und eine geringe Wärmeausdehnung aus. Sie sind jedoch nicht in der Lage, Messelemente mit hoher Wärmeentwicklung (T > 250 °C) aufzunehmen.

Ein Sensorelement mit den Merkmalen des Oberbegriffes von Patentanspruch 1 ist aus der DE 102 47 857 A1 bekannt.

Aus der DE 10 2007 025 992 A1 ist ein Verfahren zur Herstellung eines MEMS-Packages bekannt. Hierbei geht es um die Verkapselung eines MEMS-Chips, wobei dieser auf einen planarisierten Metallrahmen aufgesetzt wird, der auf einem keramischen Trägersubstrat angeordnet ist. In einem thermischen Schritt wird dazu sowohl die elektrische Verbindung zwischen dem MEMS-Chip und Kontakten auf dem Trägersubstrat über Bumps vorgenommen als auch eine ausreichend dichte und mechanisch stabile Verbindung zwischen Metallrahmen und MEMS-Chip hergestellt.

Ferner ist in der US 2012/0161796 A1 ein Gassensor beschrieben, der ein nach Art einer Hotplate ausgebildetes Sensorelement aufweist.

Die DE 10 2009 008 457 A1 beschreibt ein Verfahren zur Herstellung eines Sensors mit nahtloser Umspritzung eines Sensorelementes.

Der vorliegenden Erfindung liegt die Aufgabe zugrunde, ein Sensorelement der eingangs genannten Art zur Verfügung zu stellen, das für ein Messelement mit hoher Wärmeentwicklung besonders geeignet ist.

Diese Aufgabe wird erfindungsgemäß bei einem Sensorelement der angegebenen Art durch die kennzeichnenden Merkmale von Patentanspruch 1 gelöst.

Bei einer "Hotplate" handelt es sich beispielsweise um ein aus einer geeigneten Keramik bestehendes Plättchen, das mithilfe von zwei oder mehr schmalen Armen an einem die Hotplate umgebenden Trägersubstrat gelagert ist. Eine solche Hotplate sorgt für eine thermische Entkopplung des Messelementes, insbesondere heißen Messelementes, von den entsprechenden Kontakt/Bondstellen auf dem Trägersubstrat, die mit einer Anschlussbeschaltung kontaktiert sind. Ein Beispiel einer derartigen Hotplate ist in der DE 102 47 857 A1 beschrieben.

Die Erfindung sieht nunmehr eine Kombination einer derartigen an sich bekannten Hotplate mit einem als Kunststoffmoldgehäuse ausgebildeten Funktionsgehäuse für das Sensorelement vor. Dabei ist das Trägersubstrat mit den Kontakt/Bondstellen unter Freihaltung der Hotplate in das Kunststoffmoldgehäuse integriert, und zwar zumindest teilweise. Die Kontakt/Bondstellen sowie die zugehörige Anschlussbeschaltung werden dabei vom Kunststoffmoldgehäuse aufgenommen. Das Trägersubstrat mit den Kontakt/Bondstellen sowie die entsprechende Anschlussbeschaltung sind daher in die Kunststoffmasse des Moldgehäuses eingeformt. Die Hotplate ist dabei nicht mit eingeformt, so dass weiterhin die thermische Entkopplung des Messelementes (der Hotplate) gegenüber dem Trägersubstrat bzw. den entsprechenden Kontakt/Bondstellen sichergestellt ist.

Die erfindungsgemäße Lösung macht daher die Integration eines heißen Elementes in ein Kunststofffunktionsgehäuse möglich. Das erfindungsgemäß ausgebildete Sensorelement besitzt eine hohe Medienbeständigkeit und eine besonders gute Temperaturbeständigkeit. Dies wird durch das Funktionsgehäuse aus Kunststoff sowie die insbesondere aus Keramik bestehende Hotplate mit entsprechendem Trägersubstrat sichergestellt. Durch die geringe Wärmeausdehnung des Kunststoffmateriales des Funktionsgehäuses ist eine direkte Umspritzung von elektronischen Bauteilen möglich. Die thermische Wärmeleitfähigkeit des Kunststoffes lässt sich einstellen. Weitere Vorteile sind ggf. Downsets von Bauteilen (z. B. Chip, Sensorelement), Integration zusätzlicher technischer Optionen (z. B. O-Ringdichtung), Umsetzung in Standardgehäuse.

Bei dem erfindungsgemäß ausgebildeten Sensorelement weist das Messelement, d. h. die Hotplate, zusätzlich zu einer Messfläche vorzugsweise eine Heizeinrichtung zur aktiven Beheizung der Messfläche auf. Diese Heizeinrichtung kann beispielsweise auf der der Messfläche gegenüberliegenden Fläche der Hotplate angeordnet sein. Mit der vorgesehenen Heizeinrichtung wird ein "heißes" Messelement zur Verfügung gestellt, das durch die vorgesehene thermische Entkopplung mit dem als Kunststoffmoldgehäuse ausgebildeten Funktionsgehäuse kombiniert werden kann.

Bei einer speziellen Ausführungsform der Erfindung steht das Trägersubstrat mit der Hotplate aus dem Kunststoffmoldgehäuse vor. Hierbei geht es vorzugsweise um ein sogenanntes Langsubstrat, das nur zum Teil vom Funktionsgehäuse aufgenommen wird. Der vom Funktionsgehäuse vorstehende Teil des Trägersubstrates trägt dabei die Hotplate, die über entsprechende schmale Arme in einer Ausnehmung des Trägersubstrates an diesem gelagert ist.

Bei einer anderen Ausführungsform der Erfindung ist das Trägersubstrat vollständig in das Kunststoffmoldgehäuse integriert. Bei dieser Ausführungsform besitzt das Kunststoffmoldgehäuse eine Aussparung, in der die Hotplate angeordnet ist, so dass auch in diesem Fall das Prinzip der thermischen Entkopplung der Hotplate vom umgebenden Trägersubstrat und vom Funktionsgehäuse, in das das Trägersubstrat integriert ist, gewährleistet ist. Das Kunststoffmoldgehäuse weist daher bei dieser Ausführungsform insbesondere ein Fenster auf, das die Aussparung des Trägersubstrates und die in der Aussparung angeordnete Hotplate überdeckt.

In Weiterbildung der Erfindung ist das Kunststoffmoldgehäuse mit mindestens einem Funktionsteil, insbesondere zur Gehäusebefestigung, versehen. Das Kunststoffmoldgehäuse kann selbst entsprechende Funktionsaufgaben übernehmen oder zusätzlich mit einem oder mehreren Funktionsteilen ausgestattet sein, die für solche Funktionsaufgaben vorgesehen sind. Solche Funktionen sind beispielsweise ein mechanischer Schutz, Medienschutz, eine Strömungsführung. Entsprechende Funktionsteile können zur Gehäusebefestigung (Einschraubbefestigung) dienen, für eine entsprechende Steckergeometrie sorgen etc..

Bei noch einer bevorzugten Ausführungsform der Erfindung ist die zugehörige Auswerteeinrichtung des Sensorelementes in das Kunststoffmoldgehäuse integriert.

Die Erfindung wird nachfolgend anhand von Ausführungsbeispielen in Verbindung mit der Zeichnung im Einzelnen erläutert. Es zeigen:
- Figur 1: eine schematische Draufsicht auf eine erste Ausführungsform eines Sensorelementes; und
- Figur 2: eine schematische Draufsicht auf eine zweite Ausführungsform eines Sensorelementes.

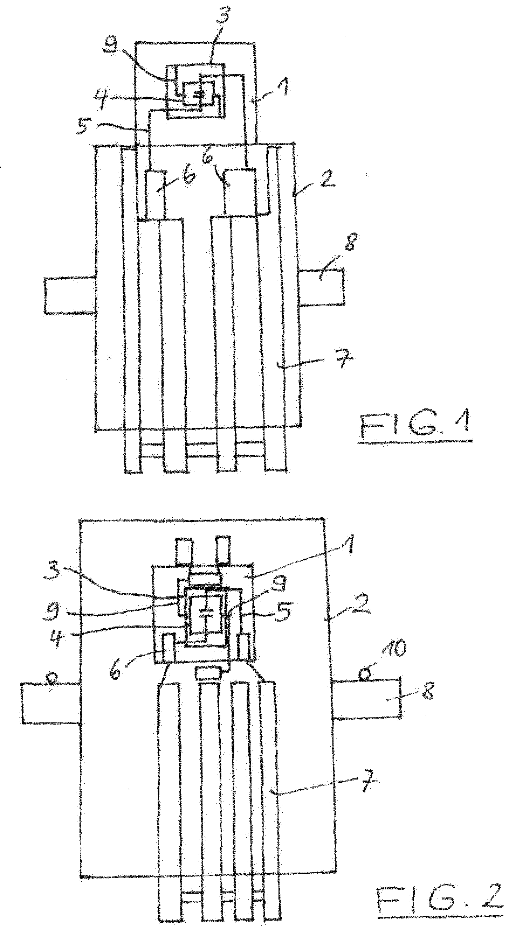

Bei dem in Figur 1 dargestellten Sensorelement ist ein mit einer Hotplate 4 versehenes Trägersubstrat 1 teilweise in ein als Kunststoffmoldgehäuse 2 ausgebildetes Funktionsgehäuse für das Sensorelement integriert. Das Trägersubstrat 1 ragt daher aus dem Funktionsgehäuse 2 heraus. Es weist eine rechteckige Aussparung 3 auf, in der das eigentliche Messelement, nämlich die Hotplate 4, über vier schmale Arme 9 am Trägersubstrat 1 gelagert ist. Entsprechende Kontaktierungen 5 für eine Messfläche, die sich auf der Oberseite der Hotplate 4 befindet, erstrecken sich über zwei Arme zu Kontaktstellen 6, die auf dem Trägersubstrat 1 angeordnet sind. Zwei weitere Kontaktierungen, die sich über die anderen beiden Arme 9 erstrecken, führen zu einer auf der Unterseite der Hotplate 4 vorgesehenen Heizeinrichtung.

Das Kunststoffmoldgehäuse 2 deckt einen Teil der Kontaktierungen 5 sowie die Kontaktstellen 6 auf dem Trägersubstrat 1 ab. Es weist ferner eine entsprechende Beschaltung auf, von der Leiterbahnen 7 gezeigt sind, die an die Kontaktstellen 6 angeschlossen sind. Das Kunststoffmoldgehäuse 2 ist direkt an das Trägersubstrat 1 angeformt und umschließt dieses in abgedichteter Weise. Es trägt ferner ein entsprechendes Funktionsteil 8, das beispielsweise als Einschraubhilfe ausgebildet sein kann.

Bei der in Figur 2 dargestellten Ausführungsform eines Sensorelementes ist das Trägersubstrat 1 der Hotplate 4 vollständig in das als Funktionsgehäuse dienende Kunststoffmoldgehäuse 2 integriert. Auch bei dieser Ausführungsform weist das Trägergehäuse 1 eine etwa rechteckige Aussparung 3 auf, innerhalb der eine Hotplate 4 an entsprechenden Trägerarmen 9, die zum Trägersubstrat führen, gelagert ist. Auf den Armen 9 befinden sich Kontaktierungen 5, welche zu entsprechenden Kontakt/Bondstellen 6 führen. Von den Kontakt/Bondstellen 6 aus erstrecken sich Leiterbahnen 7, die Teil einer entsprechenden Beschaltung bilden.

Auch bei dieser Ausführungsform besitzt das Kunststoffmoldgehäuse 2 ein als Einschraubhilfe ausgebildetes Funktionsteil 8, das bei dieser Ausführungsform einen O-Ring 10 trägt.

Während bei der Ausführungsform der Figur 1 ein sogenanntes Langsubstrat als Trägersubstrat dient, kommt bei der Ausführungsform der Figur 2 ein etwa quadratisches Trägersubstrat 1 zur Anwendung. Bei der Ausführungsform der Figur 2 ist im Kunststoffmoldgehäuse 2 ein geeignetes Fenster für die Aussparung 3 vorgesehen, in der sich die Hotplate 4 befindet.

## Patentansprüche

1. Sensorelement mit einem Messelement, das als Hotplate (4) ausgebildet ist, die mithilfe von schmalen Armen (9) weitgehend thermisch entkoppelt an einem Trägersubstrat (1) gelagert ist, das zum Messelement führende und in Kontakt/Bondstellen (6) auf dem Trägersubstrat (1) endende Kontaktierungen (5) trägt, **dadurch gekenn** - **zeichnet**, dass das Sensorelement ein das Messelement zumindest teilweise umgebendes, als Kunststoffmoldgehäuse ausgebildetes Funktionsgehäuse aufweist und dass das Trägersubstrat (1) mit den Kontakt/Bondstellen (6) unter Freihaltung der Hotplate (4) in das eine Anschlussbeschaltung für die Kontakt/Bondstellen (6) enthaltende Kunststoffmoldgehäuse (2) zumindest teilweise integriert ist, wobei das Trägersubstrat (1) mit der Hotplate (4) aus dem Kunststoffmoldgehäuse (2) vorsteht.

2. Sensorelement nach Anspruch 1, **dadurch gekennzeichnet, dass** das Messelement zusätzlich zu einer Messfläche eine Heizeinrichtung zur aktiven Beheizung der Messfläche aufweist.

3. Sensorelement nach Anspruch 1 oder 2, **dadurch gekennzeichnet, dass** das Kunststoffmoldgehäuse (2) eine Aussparung aufweist, in der die Hotplate (4) angeordnet ist.

4. Sensorelement nach einem der vorangehenden Ansprüche, **dadurch gekennzeichnet, dass** das Kunststoffmoldgehäuse (2) mit mindestens einem Funktionsteil (8), insbesondere zur Gehäusebefestigung, versehen ist.

5. Sensorelement nach einem der vorangehenden Ansprüche, **dadurch gekennzeichnet, dass** die zugehörige Auswerteeinrichtung des Sensorelementes in das Kunststoffmoldgehäuse (2) integriert ist.

## Claims

1. Sensor element comprising a measuring element, which is designed as a hot plate (4), which is mounted on a carrier substrate (1) by means of narrow arms (9) in a broadly thermally decoupled manner, said carrier substrate (1) being provided with contacts (5) which lead to the measuring element and which terminate in contact/bonding points (6) on the carrier substrate (1), **characterized in that** the sensor element has a functional housing, which at least partially surrounds the measuring element and is designed as a plastic molded housing, and **in that** the carrier substrate (1) together with the contact/bonding points (6) is at least partially integrated into the plastic molded housing (2), leaving the hot plate (4) exposed, said housing containing connection wiring for the contact/bonding points (6), wherein the carrier substrate (1) together with the hot plate (4) protrudes from the plastic molded housing (2).

2. Sensor element according to Claim 1,
**characterized in that**
the measuring element comprises, in addition to a measuring surface, a heating device for actively heating the measuring surface.

3. Sensor element according to Claim 1 or 2,
**characterized in that**
the plastic molded housing (2) comprises a cutout, in which the hot plate (4) is arranged.

4. Sensor element according to any one of the previous claims,
**characterized in that**
the plastic molded housing (2) is provided with at least one functional part (8), in particular for securing the housing.

5. Sensor element according to any one of the previous claims,
**characterized in that**
the associated evaluation device for the sensor element is integrated into the plastic molded housing (2).

## Revendications

1. Élément capteur comportant un élément de mesure réalisé sous la forme d'une plaque chauffante (4) qui est montée de manière sensiblement découplée thermiquement au moyen de bras minces (9) sur un substrat de support (1) qui porte des éléments de contact (5) menant à l'élément de mesure et se terminant par des plages de contact/connexion (6) sur le substrat de support (1),
**caractérisé en ce que** l'élément capteur comporte un boîtier fonctionnel qui entoure au moins partiellement l'élément de mesure et est réalisé sous la forme d'un boîtier moulé en matière plastique et **en ce que** le substrat de support (1) est au moins partiellement intégré avec les plages de contact/connexion (6) tout en maintenant libre la plaque chaude (4) dans le boîtier moulé en matière plastique (2) contenant un circuit de raccordement des plages de contact/connexion (6), dans lequel le substrat de support (1) fait saillie avec la plaque chauffante (4) hors du boîtier moulé en matière plastique (2).

2. Élément capteur selon la revendication 1,
**caractérisé en ce que** l'élément de mesure comporte, en plus d'une surface de mesure, un dispositif de chauffage pour le chauffage actif de la surface de mesure.

3. Élément capteur selon la revendication 1 ou 2, **caractérisé en ce que** le boîtier moulé en matière plastique (2) comporte un évidement dans lequel est disposée la plaque chauffante (4).

4. Élément capteur selon l'une des revendications précédentes,
**caractérisé en ce que** le boîtier moulé en matière plastique (2) est doté d'au moins une partie fonctionnelle (8), en particulier pour la fixation du boîtier.

5. Élément capteur selon l'une des revendications précédentes,
**caractérisé en ce que** le dispositif d'évaluation associé à l'élément capteur est intégré dans le boîtier moulé en matière plastique (2).
